# EUROPEAN PATENT APPLICATION

(11) **EP 1 480 264 A1**
(43) Date of publication of application: **24.11.2004**
(21) Application number: 03253162.6
(22) Date of filing: 21.05.2003
(51) Int. Cl.: H01L 21/58

(54) **Electrical circuit device**

(71) Applicant: Alps Electric Technology Centre (UK) Ltd., Milton Keynes MK8 8LW (GB)
(72) Inventor: Muthiah, Thirumaran Alps Elect. Tech Cter (UK) Ltd, Wymbush, Milton Keynes MK8 8LW (GB); Takayama, A., c/o Alps Elec. Tech. Centre (Uk) Ltd, Wymbush, Milton Keynes MK8 8LW (GB)
(74) Representative: Kensett, John Hinton

(57) **Abstract**

An electrical circuit device, comprising a first substrate (1), a second substrate (13) having a conductive track pattern (15) on at least its upper side, and a cut-out (12) into which an electrical component is mountable, the component being connectable to the tracks by any one or more electrical wires (17, 18), the component being mounted within the cut-out upon the first substrate by means of either glue or solder material (17), wherein one or more pockets (19-22) are formed in the under surface of the second substrate adjacent to the cut-out portion for receiving excess solder or glue when the electrical component is mounted.

## Description

This invention relates to an electrical circuit device. In particular, it relates to electrical circuit devices such as microwave circuits.

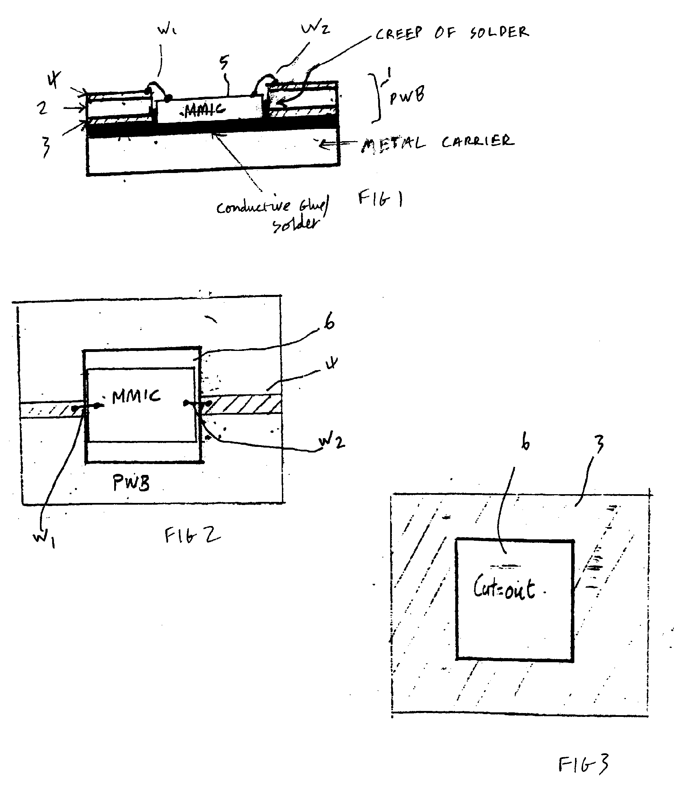

Integrated circuits for use in the microwave realm, typically known as MMIC's (Monolithic Microwave Integrated Circuits) are generally bonded onto a metal carrier, which also adds as a substrate for the transmission line to which the circuit is connected. A previously proposed transmission line shown in Figures 1 to 3 generally comprises a PWB (printed wiring board) 1 comprising a dielectric layer 2 having on its bottom layer a generally continuous layer 3 of a conductive material to form a bottom electrode and on its top layer a conductive track pattern 4 to form a top electrode. These are generally formed so that the transmission line has a predetermined impedance, typically of 50 Ω. A cut-out 6 is formed in the PWB and a MMIC 5 or other circuit component is mounted within this cut out. Terminals on the MMIC contact with the transmission line via wires W1 and W2 as shown in Figures 1 and 2.

In these figures, Figure 1 shows a cross sectional view through a circuit structure comprising metal carrier, PWB and MMIC, Figure 2 shows a top view of a PWB and MMIC assembly and Figure 3 shows a bottom view of the PWB, all of the prior art.

In such prior art arrangements, the MMIC is bonded to the metal carrier by means of a conductive glue, adhesive or solder. However, because the cut-out has to be of slightly larger dimensions than the MMIC, in order for the MMIC to be fitted into it, then when the MMIC is placed within the cut out and pushed downwards into contact with the carrier through the conductive glue, the conductive glue can tend to creep up into the gap between the MMIC and PWB, as shown in Figure 1. In effect the glue is displaced into this gap when the MMIC is bonded onto the carrier and this can be problematic, since it can affect the bonding of the wires or can affect the impedance of the circuit, having serious effects on the performance of the circuit. Up to now, the only way to try to control this creep up is by careful process control and this can be cumbersome and/or costly.

The present invention arose in an attempt to provide an improved circuit and method for avoiding or minimising such creep.

According to the present invention in the first aspect there is provided an electric circuit device, comprising a first substrate, a second substrate with a lower surface connected with the upper surface of said first substrate through conductive layer, and an electrical component being connected with the circuit on said second substrate with the wire electric, the electrical component being arranged in a parts insertion means in said second substrate and conductive layer, and said electrical component being connected through electroconductive adhesive on the upper surface of said first substrate, an excess solder pocket bordering on said parts insertion means.

In a further aspect, there is provided an electric circuit device, comprising a first substrate, a second substrate having a conductive track pattern on at least its upper side, and a cut-out into which an electrical component is mountable, the component being connectable to the tracks by one or more electrical wires, the component being mounted within the cut-out upon the first substrate by means of glue or solder material, wherein one or more pockets are formed in the under surface of the second substrate adjacent to the cut-out portion for receiving excess solder or glue when the electrical component is mounted.

The pocket or pockets ensure that the solder or glue does not overflow, or affect the performance of the device.

The invention further provides a printed wiring board comprising a dielectric layer, a lower conductive layer forming a first electrode and an upper conductive layer or track pattern, the board having a through-hole cut-out for receiving an electrical component and at least one pocket formed on the lower surface, the pocket adjacent to the cut-out, reducing the depth of the board at the pocket.

Preferably, pockets are formed in the lower circuit portion, which pockets do not extend to the area directly underneath the upper circuit path of the PWB.

Preferably, two or more separate pockets may be produced. Where four pockets are produced, they may be generally rectangular or square, or may have other configurations, including having at least some arcuate edges.

The invention further provides a method of preventing creep of conductive glue or solder when a component is inserted into a cut-out in a first substrate onto a second substrate, the method comprising forming at least one pocket in a lower surface of the first substrate where it contacts the second substrate, and adjacent to the cut-out portion, the pocket being adapted to receive excess solder or adhesive or glue when the electrical component is placed in position.

Embodiments of the invention will now be described, by way of example only, with reference to the accompanying drawings in which:
Figures 1 to 3 show a previously proposed circuit device;

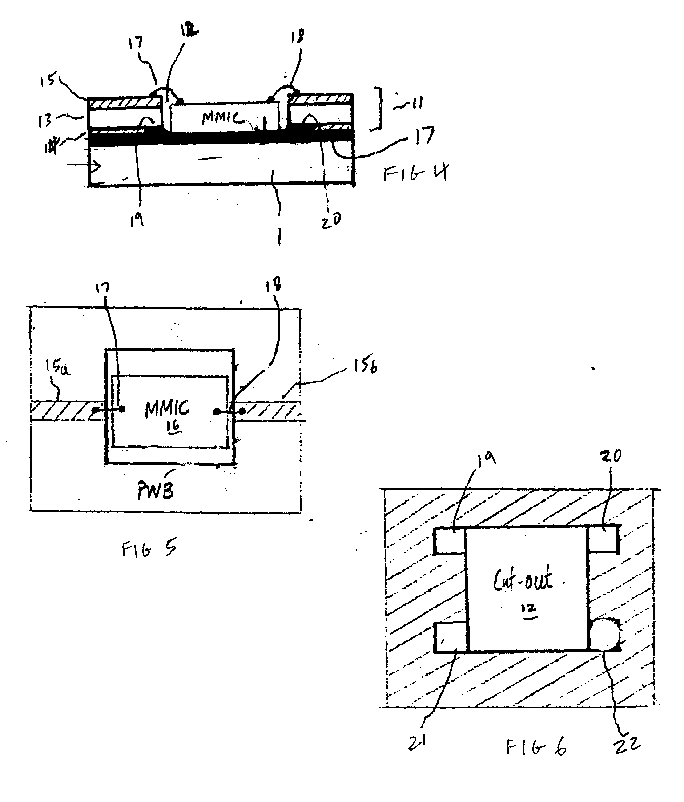

Figure 4 shows a cross-section through a circuit device;
Figure 5 shows a plan view of the device;
Figure 6 shows a bottom view of a PWB;

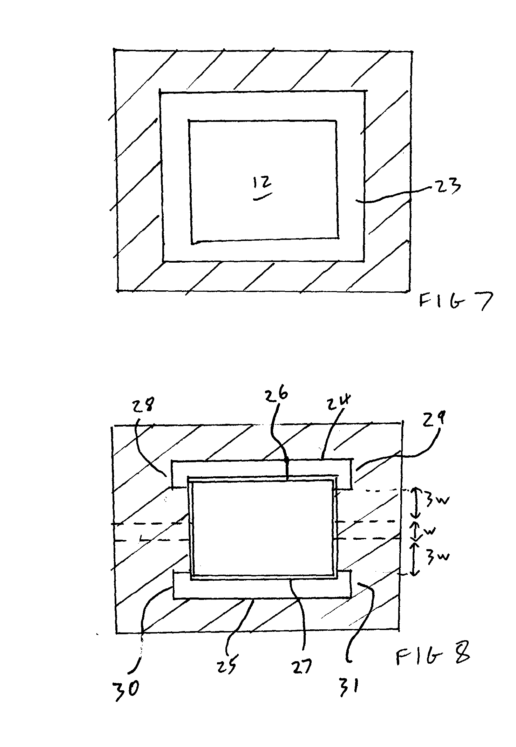

Figure 7 shows a bottom view of an alternative embodiment; and
Figure 8 shows a bottom view of a further embodiment.

Figures 4 to 6 show a first embodiment of a circuit device. Referring to Figure 4, the device comprises a metal carrier 10 forming a first substrate. A PWB 11 having a central cut-out 12 is mounted upon carrier 1. The PWB comprises a dielectric layer 13 having on its bottom layer a generally continuous layer 14 of a conductive material forming a bottom electrode and (generally the ground electrode) on its top layer a conductive track pattern 15 and in this case comprises two tracks 15a, 15b, heading away from each other opposing sides. Pattern 15 is shown more clearly in Figure 5. A MMIC 16 is mounted within cut-out 12 and connected by wires 17 and 18 to conduct a track 15.

The PWB 11 and MMIC 16 are both affixed to the metal carrier 1 by means of a layer of conductive glue, adhesive or solder 17.

In embodiments of the invention, one or more parts of the bottom electrode metal layer 14 of the PWB are edged away, adjacent to the cut-out to form one or more pockets. These are shown at 19 and 20 in Figure 4 and more clearly shown in Figure 6. In this embodiment, four additional pockets 19, 20, 21 and 22 and these extend from the cut-out as generally square or rectangular areas in which the whole, or part of, the bottom electrode layer 14 is cut-out. This may be only a partial layer which still leaves a smaller thickness layer of conductive material 14 or the conductive material may be entirely removed. Alternatively, part of the dielectric layer 13 may be removed as well. The pocket is in effect formed by removing part of the total thickness of the PWB 11 to leave the pocket.

Although the areas are shown as rectangular or square, they may be other shapes and may be arcuate or have some arcuate edges, or may be otherwise configured.

The pockets may be formed by other processes than etching, although etching is the presently preferred method.

The effect of etching away at least part of the bottom conductive layer 14 in the vicinity of the cut-out 12 is to produce recesses 19, 20, 21 and 22. When the MMIC is placed upon the metal carrier 1, it is placed upon the layer of conductive glue or solder 17. Since this layer has a finite thickness and has not yet cured or set it can flow, then when the MMIC is pressed upon it, it tends to flow outwards. As described above, in prior art arrangements the glue tends to flow upwards in the gap of the standard cut-out between the MMIC and the PWB and can affect the performance or reliability of the product. In embodiments of the present invention, on the other hand, spaces or pockets 19, 20, 21 and 22 are provided into which the excess solder or adhesive can flow through capillary action. Thus, as shown in Figure 4, the adhesive tends to flow into these areas and thus does not flow or creep up the sides of the MMIC, as in the prior art.

Figure 7 shows an alternative for use with some sort of circuits, but usually (although not necessarily) are for use with microwave circuits or other circuits in which a precise impedance between the top and bottom layers 14 and 15 of the PWB is necessary. In this version, the conductive layer is cut-out around the whole periphery of the cut-out 12. The etched portion 23 is shown as the peripheral area around cut-out 12 in Figure 7.

Figure 8 shows another alternative embodiment, in which two generally elongate pockets 24 and 25 are formed. Each of these lies generally along the whole edge 26, 27 which lie parallel to the direction of the tracks 15. The tracks 15 are shown by dashed lines in the figure, which of course are a bottom view of the PWB. The etched portion can also extend slightly inwardly at their end 28, 29, 30 and 31 as shown. For circuits with desired impedance it is important that the etched area does not extend too close to the region directly under upper conductive track 15 since it could then affect the impedance. It has been found that if the width of the conductive track 15 is W then preferably the bottom conductive track should not be etched closer than about 3W to the vertical line defining the edges of the track W, as shown in Figure 8. Similarly, for embodiments such as Figure 6, the etched areas should not impinge closer to this vertical line than 3W away from it, where the width of the track is W.

For some embodiments, however, this minimum spacing may not be so important. As described, in the currently preferred embodiments, four separate etched portions 19, 20, 21 and 22 are provided, although these may be of different shape they may be part circular or be other than quadrilateral, for example they could be generally triangular, pentagonal or be otherwise shaped. With such pockets, as the MMIC is inserted, excess solder or glue is directed outwardly and into the pockets.

## Claims

1. An electric circuit device, comprising a first substrate, a second substrate having a conductive track pattern on at least its upper side, and a cut-out into which an electrical component is mountable, the component being connectable to the tracks by one or more electrical wires, the component being mounted within the cut-out upon the first substrate by means of glue or solder material, wherein one or more pockets are formed in the under surface of the second substrate adjacent to the cut-out portion for receiving excess solder or glue when the electrical component is mounted.

2. An electric circuit device as claimed in Claim 1, wherein the second substrate comprises a dielectric layer having a lower conductive electrode layer and an upper conductive track pattern formed thereon, the or each pocket being formed at least partially in the lower conductive electrode.

3. An electric circuit device as claimed in Claim 1 or Claim 2, wherein at least two separate pockets are formed.

4. An electric circuit device as claimed in Claim 3, wherein four pockets are formed, at or in the vicinity of comers of the cut-out.

5. An electric circuit device as claimed in Claim 4, wherein each pocket is generally rectangular or square.

6. An electric circuit device as claimed in Claim 3, wherein each pocket extends at least along a side of the cut-out in a direction parallel to the direction of one or more tracks.

7. An electric circuit device as claimed in any preceding claim, wherein each pocket does not extend directly underneath the area defined by a track on the second substrate.

8. An electric circuit device as claimed in Claim 7, wherein when the width of a track is W, each pocket is spaced at least 3W away from the vertical plane defining the nearest edge of any track.

9. An electric circuit device as claimed in any preceding claim, wherein the electrical component is a microwave device and the second substrate is a printed wiring board.

10. A printed wiring board comprising a dielectric layer, a lower conductive layer forming a first electrode and an upper conductive layer or track pattern, the board having a through-hole cut-out for receiving an electrical component and at least one pocket formed on the lower surface, the pocket adjacent to the cut-out, reducing the depth of the board at the pocket.

11. A method of preventing creep of conductive glue or solder when a component is inserted into a cut-out in a first substrate onto a second substrate, the method comprising forming at least one pocket in a lower surface of the first substrate where it contacts the second substrate, and adjacent to the cut-out portion, the pocket being adapted to receive excess solder or adhesive or glue when the electrical component is placed in position.

12. An electric circuit device, comprising a first substrate, a second substrate with a lower surface connected with the upper surface of said first substrate through conductive layer, and an electrical component being connected with the circuit on said second substrate with the wire electric, the electrical component being arranged in a parts insertion means in said second substrate and conductive layer, and said electrical component being connected through electroconductive adhesive on the upper surface of said first substrate, an excess solder pocket bordering on said parts insertion means.
